Europäisches Patentamt

European Patent Office

Office européen des brevets

(19)

(11) Veröffentlichungsnummer: **0 020 981**
**B1**

(12) **EUROPÄISCHE PATENTSCHRIFT**

(45) Veröffentlichungstag der Patentschrift:
02.11.83

(51) Int. Cl.³: **H 01 L 23/42,** H 01 L 23/36

(21) Anmeldenummer: **80102576.8**

(22) Anmeldetag: **09.05.80**

(54) **Anordnung für die Ableitung von Wärme von hochintegrierten Halbleiterschaltungen.**

(30) Priorität: **20.06.79 US 50390**

(43) Veröffentlichungstag der Anmeldung:
**07.01.81 Patentblatt 81/1**

(45) Bekanntmachung des Hinweises auf die Patenterteilung:
**02.11.83 Patentblatt 83/44**

(84) Benannte Vertragsstaaten:
**DE FR GB**

(56) Entgegenhaltungen:
**IBM TECHNICAL DISCLOSURE BULLETIN, Band 20, Nr.
6, November 1977, New York, USA S. OKTAY et al.
"Dendrite conduction module", Seite 2218
IBM TECHNICAL DISCLOSURE BULLETIN, Band 21, Nr.
9, Februar 1979, New York, USA H. PARSAPOUR "Hook
and loop thermal conductive mesh", Seite 3672
IBM TECHNICAL DISCLOSURE BULLETIN, Band 21, Nr.
5, Oktober 1978, New York, USA R.G. DESSAUER et al.
"Brush tipped piston for thermal conduction", Seite
1857
IBM TECHNICAL DISCLOSURE BULLETIN, Band 20, Nr.
7, Dezember 1977, New York, USA R.G. MEEKER et al.
"Module thermal cap for semiconductor chip package"
Seiten 2699-2701
IBM TECHNICAL DISCLOSURE BULLETIN, Band 20, Nr.
11B, April 1978, New York, USA E. BERNDLMAIER et al.
"Liquid metal-cooled integrated circuit module
structures", Seiten 4817-4818**

(73) Patentinhaber: **International Business Machines
Corporation, Old Orchard Road, Armonk, N.Y. 10504 (US)**

(72) Erfinder: **Babuka, Robert, 128 Hawthorne Street, Vestal,
New York 13850 (US)**
Erfinder: **Heath, Robert Ellis, 528 Twist Run Road,
Endwell, New York 13760 (US)**
Erfinder: **Saxenmeyer Jr., George John, Barton Road,
Apalachin, New York 13732 (US)**
Erfinder: **Schultz, Lewis Keating, Road No. 1, Sayre,
Pennsylvania 18840 (US)**

(74) Vertreter: **Schröder, Otto H., Dr.-Ing., c/o International
Business Machines Corporation Zurich Patent
Operations Säumerstrasse 4, CH-8803 Rüschlikon/ZH
(CH)**

Anordnung für die Ableitung von Wärme von hochintegrierten Halbleiterschaltungen

Die Erfindung betrifft eine Anordnung für die Ableitung von Wärme, wie sie im Oberbegriff des Anspruchs 1 angegeben ist.

Als eine der grössten Schwierigkeiten bei dem Streben nach immer grösserer Schaltungsdichte und immer höherer Leistung bei hochintegrierten bipolaren Schaltungen hat sich die Ableitung der Wärme herausgestellt, die durch die elektrische Verlustleistung auf diesen Halbleiterplättchen erzeugt wird. Erhöht man die Verlustleistung durch immer grössere Schaltungsdichte je Flächeneinheit auf dem Halbleiterplättchen ohne sonstige Änderungen, dann ergibt sich naturgemäss eine entsprechende Erhöhung der Betriebstemperatur des Halbleiterplättchens. Das hat unglücklicherweise jedoch eine starke Verringerung der Lebensdauer des Halbleiterplättchens zur Folge, wobei sich diese Verringerung der Lebensdauer exponentiell und nicht proportional entwickelt.

Daher hat man grosse Anstrengungen bei den entsprechenden Packungen für Halbleiterplättchen unternommen, so dass der Wärmeübergangswiderstand zwischen einem Halbleiterplättchen und seiner Umgebung weitgehend verringert werden kann. Führt dies zum Erfolg, dann kann auch die Schaltungsdichte auf den Halbleiterplättchen ohne nachteilige Auswirkungen auf das Betriebsverhalten und die Zuverlässigkeit der Halbleiterplättchen erhöht werden.

Eine Möglichkeit, hochintegrierte Halbleiterplättchen in einem Modul unterzubringen, ist im IBM TDB, September 1976, Band 19, Nr. 4, in einem Aufsatz von B. Clark auf Seite 1336 beschrieben. Bei dieser Anordnung ist das Halbleiterplättchen über eine Anzahl von Lötkügelchen mit einer Anzahl von leitenden Kontaktflächen auf einem keramischen Substrat verbunden. Die Kontaktflächen sind ihrerseits wieder mit Kontaktstiften verbunden, die sich von dem Modul nach aussen erstrecken, das wiederum durch eine metallische Kappe abgeschlossen ist. Die Wärmeübertragung von dem Halbleiterplättchen erfolgt üblicherweise über die Lötkügelchen und die Kontaktflächen an die Kontaktstifte und ausserdem von dem Substrat und dem Halbleiterplättchen nach der metallischen Kappe. In diesem Fall wird die Wärmeübertragung durch einen zusätzlichen am Umfang angeordneten Flansch verbessert, der eine zusätzliche Kühlrippe für die Wärmeübertragung an die Umgebungsluft darstellt.

In einem Aufsatz von D. Baldereo und andere im IBM Technical Disclosure Bulletin, April 1977, Band 19, Nr. 11, auf den Seiten 4165 und 4166 wird vorgeschlagen, dass die für elektrische Anschlüsse nicht verwendeten Kontaktflächen für unmittelbare Wärmeübertragung direkt an die Kappe des Moduls angeschlossen werden sollen. Der Aufsatz von J. Lynch und andere im IBM Technical Disclosure Bulletin, Juni 1977, Band 20, Nr. 1, auf Seite 143 schlägt weiterhin einen wärmeleitenden Kolben vor, der unter Federvorspannung in Berührung mit dem Halbleiterplättchen gehalten ist und eine wesentliche Wärmesenke bildet, sowie die Verwendung eines festen Materials mit niedrigem Ausdehnungskoeffizienten wie z.B. Molybdän oder Berylliumoxid, das den Kolben und die Feder umgibt und die Wärmeleitfähigkeit weiter erhöht. In einem Aufsatz von E. Berndlmaier und andere in IBM Technical Disclosure Bulletin, Band 20, Nr. 5, Oktober 1977, Seiten 1772 und 1773, wird eine weitere Lösung dieses Problems vorgeschlagen. Bei dieser bekannten Anordnung ist das Halbleiterplättchen in einem abgedichteten Hohlraum innerhalb des Moduls untergebracht, wobei der Hohlraum nach Art eines Balges aufgebaut ist und eine geringe Menge eines flüssigen Metalls enthält. Ein Zapfen, der sich von der Kappe des Moduls nach innen erstreckt, steht dabei in Berührung mit dem Balg und ergibt somit eine sehr grosse Berührungsfläche mit dem flüssigen Metall und fördert damit die Wärmeübertragung an die Kappe. Die Verwendung eines thermischen Mediums, wie z.B. eines flüssigen Metalls, einer Wärmeübertragungsflüssigkeit oder eines Fettes oder Öles zur Erhöhung der Wärmeübertragung von dem Halbleiterplättchen nach aussen ist in einem Aufsatz von A. Arnold und anderen im IBM Technical Disclosure Bulletin, Dezember 1977, Band 20, Nr. 6, auf Seiten 2675 und 2676 beschrieben.

Die Aufsätze von R.N. Spaight und P. Ginnings und andere, die im IBM Technical Disclosure Bulletin, Dezember 1977, Band 20, Nr. 7, auf Seite 2614 bzw. April 1979, Band 21, Nr. 11, auf Seite 4493 erschienen sind, beschreiben ebenfalls die Verwendung eines formbaren Wärmeübertragungsmediums für die Verbesserung der Wärmeableitung von einem Halbleiterplättchen nach der Kappe des Moduls.

Die Verwendung von dendritischen Vorsprüngen für Hochtemperaturanwendungen wurde durch J. Cuomo im IBM Technical Disclosure Bulletin, September 1975, Band 18, Nr. 4, auf Seiten 1239 bis 1240 beschrieben. In diesem Aufsatz wurden Wolframdendriten zur Wärmeleitung in einem Wärmerohr als inerter Docht verwendet. Ausserdem wurde die Anwendung von Dendriten zur Erhöhung der Oberflächen für alle Arten von Wärmeübertragung vorgeschlagen, insbesondere auf einer Oberfläche eines Halbleiterplättchens für eine Berührung eines mit einer kugelförmigen Spitze versehenen Kolbens in einem Modul. Diese Anordnung ist in einem Aufsatz von S. Oktay und andere im IBM Technical Disclosure Bulletin, November 1977, Band 20, Nr. 6, auf Seite 2218 beschrieben. Eine weitere Anwendung von Dendriten zur Verbesserung der Kühlung von Halbleiterplättchen ist im IBM Technical Disclosure Bulletin, Februar 1972, Band 14, Nr. 9, auf Seite 2690 in dem Aufsatz von E. Bakelaar und anderen dargestellt. Bei dieser Anordnung ist eine Anzahl von mittels Lötkügelchen befestigten Halbleiterplättchen auf ihren Oberflächen mit einem Überzug von Dendriten versehen, während die innere Oberfläche eines Wärmerohres in gleicher Weise mit einem Überzug solcher Dendriten versehen ist. Die Dendriten auf der Oberfläche des Halbleiterplättchens und die Dendriten auf der innern Oberfläche des Wärmerohres sind dabei miteinander in Berührung, und eine dielektrische Flüssigkeit, die das Wärmerohr zum Teil ausfüllt, verbessert die Kapillarwirkung des dielektrischen Kühlmittels und erhöht auch die Kühlwirkung für die Halbleiterplättchen. Durch den Aufsatz von F. Antonucci und andere im IBM Technical Disclosure Bulletin, Dezember 1978, Band 21, Nr. 7, Seiten 2910 und 2911, ist dargestellt, dass ein genau gesteuertes Wachstum von Dendriten dazu verwendet werden kann, die Zugfestigkeit der Lötverbindung zwischen Halbleiterplättchen und Substrat in einem Modul zu erhöhen, während gleichzeitig der elektrische Widerstand dieser Verbindung verringert wird.

Keine dieser bekannten Techniken hat sich jedoch als vollkommen zufriedenstellend herausgestellt. Die Befestigung mittels Lötkügelchen ist in der Tat nicht sehr wirkungsvoll bei der Ableitung von Wärme von dem Halbleiterplättchen, da der gesamte Querschnitt aller solcher Lötverbindungen im Vergleich mit der Oberfläche des Halbleiterplättchens sehr klein ist. Dadurch wird der grösste Teil der Wärme durch natürliche Konvektion von der Oberfläche des Halbleiterplättchens abgeführt.

Eng begrenzte Verbesserungen des Wirkungsgrads bei der Kühlung hat man durch Verwendung eines flüssigen oder festen Wärmeübertragungsmediums erreicht, doch haben solche Verbesserungen zu entsprechenden Nachteilen und Schwierigkeiten bei den Packungen geführt. Die Verwendung eines massiven Kolbens kann zur Folge haben, dass wegen mangelhafter Anpassung der Wärmeausdehnungskoeffizienten das Substrat zerbricht. Verwendet man ein flüssiges Wärmeübertragungsmedium, so können sich Schwierigkeiten in bezug auf Migration des Vakuums, Wechselwirkungen mit den Komponenten des Moduls und/oder bei der Abdichtung des Moduls ergeben.

Es wurde gefordert, dass eine wesentliche Verbesserung beim Kosten-/Leistungsverhältnis bei der Wärmeableitung von einem Halbleiterplättchen dadurch erzielt werden könnte, dass eine Wärmesenke eines hochwärmeleitenden massiven oder festen Materials in unmittelbarer Berührung mit der rückseitigen Oberfläche des Halbleiterplättchens gebracht wird. Ein flüssiges Metall schien für diese Rolle besonders gut geeignet zu sein, da es eine hohe Wärmeleitfähigkeit aufweist und sich ausserdem verformt und damit einen innigen Kontakt mit dem Halbleiterplättchen herstellt, ohne dass unnötig hoher mechanischer Druck erforderlich ist. Ausserdem zeigt ein flüssiges Metall eine überlegene Wärmeleitfähigkeit gegenüber anderen flüssigen Medien und Ölen oder Fetten und ist ausserdem chemisch stabil. Unter dem Einfluss von thermischen Zyklen und mechanischer Vibration wurde jedoch festgestellt, dass flüssiges Metall und auch alle anderen thermischen Flüssigkeiten einer gewissen Migration von der rückseitigen Oberfläche des Halbleiterplättchens unterliegen, so dass der Wärmeableitwirkungsgrad sich entsprechend verringert. Es wurde ausserdem festgestellt, dass ein flüssiges Metall dazu neigt, auf seiner äusseren Oberfläche einen Oxidfilm zu bilden, der seine Wärmeleitfähigkeit verringert und damit auch den Kühlungswirkungsgrad für das Halbleiterplättchen.

Die der Erfindung zugrunde liegende Aufgabe kann also dahingehend definiert werden, dass versucht werden soll, die Wärmeableitung für innerhalb einer Kappe angeordnete Halbleiterplättchen noch weiter zu verbessern, so dass auch bei höherem Integrationsgrad und noch grösserer Schaltungsdichte die Wärmeableitung immer noch gut genug ist. Diese der Erfindung zugrunde liegende Aufgabe wird durch die im kennzeichnenden Teil des Anspruchs 1 angegebenen Mittel gelöst. Dadurch ergibt sich ein einheitlicher Wärmeübertragungspfad mit verringertem Wärmeübergangswiderstand vom Halbleiterplättchen nach der Kappe des Moduls.

Die Erfindung wird nunmehr anhand eines Ausführungsbeispiels in Verbindung mit den beigefügten Zeichnungen im einzelnen näher erläutert. Dabei zeigt

Fig. 1 schematisch ein Modul mit einem darin befindlichen, mit integrierten Schaltungen versehenen Halbleiterplättchen, das im Betrieb gemäss der Erfindung gekühlt werden soll, und

Fig. 2 eine mehr ins einzelne gehende Teilquerschnittsansicht der metallischen dentritischen Vorsprünge und der aus flüssigem Metall bestehenden Zwischenschicht gemäss der Erfindung.

Beschreibung der bevorzugten Ausführungsform der Erfindung

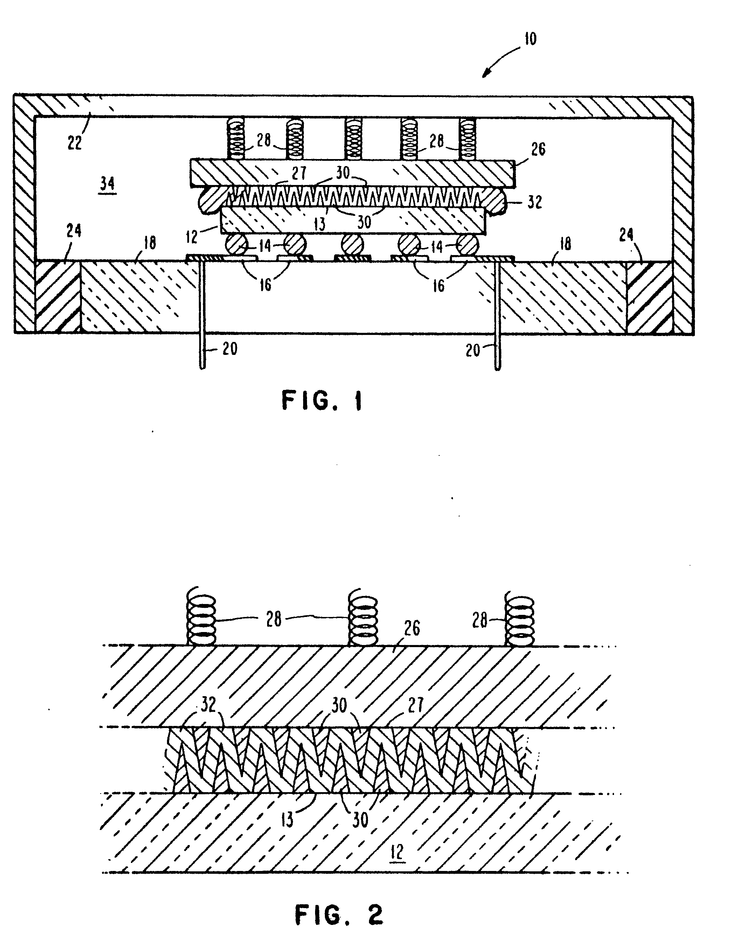

In den beiden Figuren sind zur Bezeichnung gleicher Teile die gleichen Bezugsziffern verwendet. Fig. 1 zeigt schematisch ein ein Halbleiterplättchen 12 enthaltendes Modul 10. Selbstverständlich kann mehr als ein Halbleiterplättchen in dem Modul untergebracht sein, doch ist hier zur Vereinfachung nur ein Halbleiterplättchen dargestellt.

Das Modul 10 enthält also ein mit integrierten Schaltungen versehenes Halbleiterplättchen 12, das mit Hilfe einer Anzahl von Lötkügelchen 14 an Kontaktflächen 16 elektrisch angeschlossen ist. Die Kontaktflächen 16 sind auf der Oberfläche eines keramischen Substrats 18 angeordnet und sind mit Anschlussstiften 20 versehen, die sich durch das Substrat 18 nach aussen erstrecken und die Verbindung mit dem Halbleiterplättchen 12 herstellen. Das Modul 10 weist eine Kappe 22 auf, die vorzugsweise aus Aluminium oder einem anderen geeigneten leitenden Material besteht und welche zur Bildung einer hermetisch dichten Packung mit Hilfe einer Dichtung 24 am Substrat 18 dicht abgeschlossen ist.

Ausserdem ist eine massive metallische Wärmesenke 26 vorgesehen, die durch Federn 28 nach unten gegen das Halbleiterplättchen 12 gedrückt wird. Es sei darauf hingewiesen, dass die der Vorspannung dienenden Federn 18 mindestens thermisch mit der Kappe 22 und der Wärmesenke 26 verbunden sind und aus wärmeleitendem Material bestehen.

Die einander gegenüberliegenden Oberflächen des Halbleiterplättchens 12 und der Wärmesenke 26 sind mit einer grossen Anzahl metallischer dendritischer Vorsprünge 30 versehen, die sich von den einander gegenüberliegenden Oberflächen weg erstrecken. Diese dendritischen Vorsprünge 30 werden vorzugsweise durch elektrolytischen Niederschlag auf der Oberfläche 13 des Halbleiterplättchens und auf der Oberfläche 27 der Wärmesenke in der Weise aufgebracht, dass man ein galvanisches Bad verwendet, das mit einer höheren als der üblichen Stromdichte betrieben wird und eine geringere als die übliche Metallionenkonzentration aufweist. Anderseits können diese dendritischen Vorsprünge 30 auch mit anderen Verfahren, beispielsweise durch chemischen Niederschlag, aus der Dampfphase gewonnen werden.

Eine Schicht 32 aus flüssigem Metall wird zwischen dem Halbleiterplättchen 12 und der Wärmesenke 26 vorgesehen. Die aus flüssigem Metall bestehende Schicht 32 besteht vorzugsweise aus einer flüssigen Galliumlegierung, die voll verträglich mit anderen Elementen des Moduls ist. Diese Legierung hat unter allen zu erwartenden Betriebsbedingungen praktisch den Dampfdruck Null und löst sich in bekannten Wärmeübertragungsmedien wie Helium, Stickstoff oder einem Fluorkohlenstoff nicht auf und reagiert auch nicht mit diesen. Ein solches Wärmeübertragungsmedium 34 wird für die weitere Verbesserung der Kühlung des Halbleiterplättchens benutzt und füllt den Innenraum des Moduls 10 aus.

Im Betrieb wird das Halbleiterplättchen 12 in dem Modul 10 wie oben beschrieben befestigt, und dann wird die aus einem flüssigen Metall bestehende Schicht 32 auf der oberen Oberfläche 13 über die metallischen dendritischen Vorsprünge 30, die sich nach oben erstrecken, aufgebracht. Die Kappe 22, an der die Wärmesenke 26 und die der Vorspannung dienenden Federn 28 angeschlossen sind, wird dann in ihre richtige Lage gebracht und mit dem Substrat 18 an der Dichtung 24 dicht verbunden. Wenn die Kappe 22 aufgesetzt ist, dann drängen die Federn 28 die Wärmesenke 26 und ihre sich nach unten erstreckenden dendritischen Vorsprünge 30 so nach unten, dass sie in die aus flüssigem Metall bestehende Schicht 32 eindringen. Die aus flüssigem Metall bestehende Schicht 32 wird auf diese Weise zwischen die beiden Gruppen von dendritischen Vorsprüngen 30 eingelagert und von diesen durchdrungen. Der durch die Federn 28 ausgeübte Vorspannungsdruck bewirkt, dass das flüssige Metall alle offenen Räume zwischen dem Halbleiterplättchen 12 und der Wärmesenke 26 zerstörungsfrei ausfüllt. Die Anpassung der aus flüssigem Metall bestehenden Schicht 32 und der dendritischen Vorsprünge 30 aneinander ergibt eine selbstzentrierende Wirkung, durch die die Schicht 32 an ihrem durch den ursprünglichen Eingriff vorgesehenen Ort gehalten wird, so dass anschliessend durch die ziemlich starken Oberflächenspannungen diese Position beibehalten wird. Die Neigung flüssiger Metalle, an ihrer Oberfläche einen Oxidfilm zu bilden, der die Wärmeleitfähigkeit herabsetzt, wird durch die Anwesenheit der benetzten dendritischen Vorsprünge 30 in der Schicht 32 aus flüssigem Metall beseitigt. Eine vergrösserte schematische Darstellung dieser Anordnung der nunmehr mit einem flüssigen Metall überzogenen dendritischen Vorsprünge 30 zeigt Fig. 2.

Wenn daher die Kappe 22 dicht aufgesetzt ist und die dendritischen Vorsprünge 30, die aus flüssigem Metall bestehende Schicht 32 durchbohrend oder durchdringend gedrängt worden sind, dann erhält man eine einheitliche Wärmeübertragung, die sich von der gesamten oberen Oberfläche 13 des Halbleiterplättchens über die dendritischen Vorsprünge 30 und die aus flüssigem Metall bestehende Schicht 32 die untere Oberfläche 27 der Wärmesenke 26 und die Federn 28 nach der Kappe 22 des Moduls 10 erstreckt. Dieser Pfad relativ geringen Wärmewiderstandes bewirkt eine sehr gute Wärmeableitung vom Halbleiterplättchen 12. Die Kühlung wird ausserdem noch durch ein Wärmeübertragungsmedium 34 weiter unterstützt, das den Innenraum des Moduls 12 ausfüllt.

## Patentansprüche

1. Anordnung für die Ableitung von Wärme aus einem mit integrierten Schaltungen versehenen Halbleiterplättchen in einem von einer gut wärmeleitenden Kappe umschlossenen Modul, bei der innerhalb der Kappe (22) gegenüber dem auf einem Substrat (18) angelöteten (14, 16) Halbleiterplättchen (12) eine Wärmesenke (26) angeordnet ist, dadurch gekennzeichnet, dass auf den beiden einander gegenüberliegenden Oberflächen (13, 27) des Halbleiterplättchens (12) bzw. der Wärmesenke (26) eine Anzahl metallischer, dendritischer Vorsprünge (30) angeordnet ist, die aufeinander zu und miteinander ausgerichtet sind, dass zwischen den gegenüberliegenden Oberflächen des Halbleiterplättchens (12) und der Wärmesenke (26) eine Schicht (32) aus einer flüssigen metallischen Legierung vorgesehen ist und dass Mittel (28) vorgesehen sind, die einmal eine Wärmebrücke zwischen der Wärmesenke (26) und der Kappe (22) bilden und die Wärmesenke (26) federnd in Richtung auf das Halbleiterplättchen (12) derart drängen, dass alle dendritischen Vorsprünge (30) in die Schicht (32) eindringen und so eine durchgehende Wärmebrücke von dem Halbleiterplättchen (12) nach der Kappe (22) des Moduls (10) herstellen.

2. Anordnung nach Anspruch 1, dadurch gekennzeichnet, dass zur weiteren Verbesserung der Kühlung des Halbleiterplättchens (12) innerhalb des Moduls ein flüssiges Wärmeübertragungsmedium (34) vorgesehen ist.

3. Anordnung nach Anspruch 1, dadurch gekennzeichnet, dass die flüssige metallische Legierung eine flüssige Gallium-Legierung ist.

4. Anordnung nach Anspruch 1, dadurch gekennzeichnet, dass die federnden Mittel (28) die einander gegenüberliegenden Oberflächen (13, 27) mit einer solchen Kraft zusammendrängen, dass die flüssige metallische Legierung praktisch alle Hohlräume zwischen den beiden Oberflächen zerstörungsfrei ausfüllt.

5. Anordnung nach Anspruch 1 oder Anspruch 4, dadurch gekennzeichnet, dass die Anzahl der auf den beiden gegenüberliegenden Oberflächen angeordneten dendritischen Vorsprünge (30) so hoch gewählt ist, dass dadurch der Eingriff mit der flüssigen metallischen Schicht (30) aufrechterhalten und die flüssige metallische Schicht (30) festgehalten wird.

## Claims

1. Arrangement for dissipating heat from a semiconductor integrated circuit chip in a module surrounded by a cap of high thermal conductivity, where within the cap (22) opposite the semiconductor chip (12) soldered (14, 16) to a substrate (18) a heat sink (26) is provided, characterized in that on the two oppositely placed surfaces (13, 27) of the semiconductor chip (12) and of the heat sink (26) respectively a number of metallic dendritic projections (30) are arranged which face, and are in alignment with each other, that between said facing surfaces of the semiconductor chip (12) and of the heat sink (26) a layer (32) of a liquid metallic alloy is disposed, and that means (28) are provided forming a heat transfer path between the heat sink (26) and the cap (22), and which resiliently urge the heat sink (26) in the direction of the semiconductor chip (12) in such a manner that all dendritic projections (30) penetrate into the layer (23) and thus form a unitary heat transfer path from the semiconductor chip (12) to the cap (22) of the module (10).

2. Arrangement as claimed in claim 1, characterized in that for further enhancing the cooling of the semiconductor chip (12) in the module a fluid heat transfer medium (34) is provided.

3. Arrangement as claimed in claim 1, characterized in that the liquid metallic alloy is a liquid gallium alloy.

4. Arrangement as claimed in claim 1, characterized in that the resilient means (28) urge the facing surfaces (13, 27) together with such a force that the liquid metallic alloy practically fills nondestructively all cavities between the two surfaces.

5. Arrangement as claimed in claim 1 or claim 4, characterized in that the number of the dendritic projections (30) on the two facing surfaces is sufficient to maintain engagement with, and to retain the liquid metallic layer (30).

## Revendications

1. Dispositif permettant de dissiper la chaleur dégagée par une microplaquette semi-conductrice à circuits intégrés située dans un module et entourée par un capot très conducteur de chaleur, où on a, dans ledit capot (22) un puits de chaleur (26) faisant face à ladite microplaquette semi-conductrice (12) soudée (14, 16) à un substrat (18), caractérisé en ce qu'un certain nombre de projections (30) métalliques et dendritiques, disposées ensemble les unes après les autres et les unes en face des autres, sont implantées sur chacune des deux surfaces (13, 27) opposées l'une à l'autre que constituent respectivement ladite microplaquette (12) et ledit puits de chaleur (26), en ce qu'il est prévu une couche (32) en alliage métallique liquide entre les deux surfaces opposées l'une à l'autre que constituent respectivement ladite microplaquette (12) et ledit puits de chaleur (26), et, qu'il est prévu des moyens (28), qui, d'une part, forment un pont thermique entre ledit puits de chaleur (26) et ledit capot (22), et, d'autre part, poussent élastiquement ledit puits de chaleur (26) vers ladite microplaquette semi-conductrice (12) de telle sorte que la totalité desdites projections dendritiques (30) pénètrent ladite couche (32) et constituent ainsi un pont thermique continu allant de ladite microplaquette semi-conductrice (12) vers ledit capot (22) dudit module (10).

2. Dispositif selon la revendication 1, caractérisé en ce qu'il est prévu un fluide de transfert de chaleur (34) pour accroître le refroidissement de ladite microplaquette semi-conductrice (12) à l'intérieur dudit module (10).

3. Dispositif selon la revendication 1, caractérisé en ce que ledit alliage métallique liquide est un alliage liquide de gallium.

4. Dispositif selon la revendication 1, caractérisé en ce que lesdits moyens élastiques (28) pressent, l'une contre l'autre, les deux dites surfaces opposées l'une à l'autre (13, 17) avec une telle force que ledit alliage métallique liquide comble de façon non destructive pratiquement toutes les cavités situées entre les deux dites surfaces.

5. Dispositif selon la revendication 1 ou 4, caractérisé en ce que le nombre de projections dendritiques (30) implantées sur les deux dites surfaces opposées l'une à l'autre est suffisamment important pour assurer une prise ferme dans ladite couche métallique liquide (30) et pour maintenir cette dite couche.

FIG. 1

FIG. 2